# EUROPEAN PATENT APPLICATION

(11) **EP 4 831 656 A1**
(43) Date of publication of application: **28.10.2026**
(21) Application number: 24905705.0
(22) Date of filing: 23.09.2024
(51) Int. Cl.: G01R 31/08

(54) **ARC FAULT DETECTION METHOD BASED ON COMPLEMENTARY ENSEMBLE EMPIRICAL MODE DECOMPOSITION**

(30) Priority: 20.12.2023 CN 202311754008
(71) Applicant: Tianjin Aviation Electro-Mechanical, Tianjin 300308 (CN)
(72) Inventor: WU, Pengfei, Tianjin 300308 (CN); YANG, Chang, Tianjin 300308 (CN); LIU, Lijing, Tianjin 300308 (CN)
(74) Representative: Osha BWB
(86) International application number: PCT/CN2024/120403
(87) International publication number: WO 2025/130214

(57) **Abstract**

An arc fault detection method based on complementary ensemble empirical mode decomposition includes: acquiring, via an arc current acquisition system, current data in a circuit to obtain an arc current, and performing pre-processing; extracting, via a complementary ensemble empirical mode decomposition algorithm, an intrinsic mode function IMF1 component of the arc current, and performing piecewise mean processing on the IMF1 component to obtain an IMF1 component mean; then calculating, via an adjacent cycle correlation coefficient algorithm, an IMF1 component feature value to obtain an arc determination feature value, and comparing the arc determination feature value with a preset threshold to determine whether an arc fault occurs. Compared with existing arc fault detection algorithms, the feature value extraction method of the present invention has high anti-interference capability, can adapt to accurate extraction of arc fault features in a high-noise environment, has the advantages of high detection precision and low erroneous detection rate, and can meet the arc fault detection requirements of high-voltage DC power supply and distribution systems.

## Description

### TECHNICAL FIELD

The present invention relates to the technical field of aircraft power systems and electrical safety monitoring, in particular to an arc fault detection method based on complementary ensemble empirical mode decomposition.

### BACKGROUND

With the increasing electrification level of aircraft, onboard power systems have evolved through the stages of low-voltage DC, AC constant-frequency, and AC variable-frequency to meet the growing power demands of power electronic loads. As the voltage and current levels of aircraft power supply and distribution systems gradually increase, arc fault phenomena caused by aging of aircraft wire harnesses, line wear due to vibration and thermal cycling, or loose electrical connections resulting from other causes have become more frequent. However, arc fault phenomena are relatively subtle, and the resulting current and voltage fluctuations are often difficult to detect by electrical protection devices in the circuit.

Therefore, onboard high-voltage DC arc fault detection is an urgent research task.

Currently, domestic and foreign scholars have carried out relevant research on high-voltage DC arc faults. Extensive literature review indicates that the core of arc fault detection lies in analysis and selection of features. An effective arc feature often greatly improves the detection rate of an arc fault and has good anti-interference capability. For example, Dalian University of Technology proposed an arc fault detection method based on a combination of EMD and SVM in the paper "Aviation Fault Arc Detection Based on EMD-SVM." However, EMD itself has two obvious shortcomings. First, during the decomposition process of EMD, a mode mixing phenomenon may occur when IMFs are decomposed, so that a single IMF function may contain features of different time scales, leading to errors in feature analysis. Second, many iterations are required in the decomposition process of EMD, different iteration stopping conditions yield different IMFs, and the iteration stopping conditions lack a standard. Therefore, the EMD algorithm needs to be improved to ensure the effectiveness of arc fault features and to improve the precision of the arc fault detection method.

### SUMMARY

The present invention provides an arc fault detection method based on complementary ensemble empirical mode decomposition to solve the problem of high-voltage DC arc fault detection.

Technical solution of the present invention:

The present invention provides an arc fault detection method based on complementary ensemble empirical mode decomposition, the method including:
Step 1: acquiring high-voltage DC arc data and performing pre-processing to obtain data to be processed;
Step 2: extracting, via a complementary ensemble empirical mode decomposition algorithm, an intrinsic mode function component IMF1 of the data to be processed;
Step 3: performing piecewise mean processing on the mode function component IMF1 to obtain an IMF1 mean;
Step 4: performing, via a Pearson correlation coefficient, feature extraction on the IMF1 mean;
Step 5: identifying, via a preset threshold determination strategy, an arc fault.

Further, settings for acquiring high-voltage DC arc data in the Step 1 satisfy the following conditions:
1) a filter is disposed such that a sampling bandwidth of the high-voltage DC arc data is not higher than 200 kHz;
2) a sampling frequency of the high-voltage DC arc data is not lower than 500 kHz, and a sampling duration of the high-voltage DC arc data is not lower than 10 s.

Further, the pre-processing in the Step 1 specifically is:
normalizing, via a steady-state operating current in the circuit, the high-voltage DC arc data to obtain data to be processed Iarc.

Further, the Step 2 specifically includes the following steps:
1) creating Gaussian white noise w0(t), and performing positive and negative modulation on the data to be processed Iarc to obtain a current signal mixed with positive white noise Iarc(0+) and a current signal mixed with negative white noise Iarc(0-), respectively: $Iarc \left(0+\right) = Iarc + w 0 \left(t\right) ;$ $Iarc \left(0-\right) = Iarc - w 0 \left(t\right) ;$
2) decomposing, via an empirical mode decomposition algorithm, the current signal mixed with positive white noise Iarc(0+) and the current signal mixed with negative white noise Iarc(0-) to obtain intrinsic mode function components C0+ and C0-, respectively;
3) repeating the above two steps by adding different noises and performing empirical mode decomposition to obtain corresponding intrinsic mode function components Ci+ and Ci-, where i=1, 2, 3, ..., N;
4) averaging all obtained intrinsic mode function components to obtain a final decomposition result: $S + = \frac{1}{N} {\sum }_{i}^{N} Ci +$ $S - = \frac{1}{N} {\sum }_{i}^{N} Ci - ;$
   finally obtaining the intrinsic mode function component IMF1=(S+ + S-)/2, where N represents number of times white noises are added.

Further, the Step 3 specifically includes the following steps:
1) dividing the mode function component IMF1 into n segments at a time interval of 100 µs, discarding a final data segment shorter than 100 µs;
2) finding, in each of the divided segments, extreme points and coordinates thereof respectively, and recording them as a maximum value Max(k) and maximum value coordinates Maxzb(k), and a minimum value Min(k) and minimum value coordinates Minzb(k), respectively, where k=1, 2, 3, ..., n;
3) discarding the extreme points in the mode function component IMF1 to obtain a reconstructed mode function component IMF2;
4) performing mean processing on the reconstructed mode function component IMF2, wherein for points at adjacent positions of the extreme points in the reconstructed mode function component IMF2, j adjacent points of the points at the adjacent positions are taken for mean processing; and for other non-extreme points in the reconstructed mode function component IMF2, three adjacent points of the non-extreme points are taken for mean processing, where j is a set value.

Further, the Step 4 specifically includes the following steps:
1) dividing the mode function component IMF1 mean into m segments at a time interval of 100 µs to obtain a set of components imf1, imf2, ..., imfm, where m is an odd number greater than 5;
2) selecting two adjacent segments to calculate a Pearson correlation coefficient thereof to obtain an arc feature value ρ based on the following calculation formula: $ρ \left(p\right) = \frac{E \left[\left(imf\left(p\right)-μimf\left(p\right)\right)\left(imf\left(p+1\right)-μimf\left(p+1\right)\right)\right]}{σimf \left(p\right) σimf \left(p+1\right)}$ where E represents expectation, µ represents standard deviation, σ represents variance, and p=1, ..., m-1.

Further, the Step 5 specifically includes the following steps:
1) comparing each element in the arc feature value ρ with a first arc determination threshold YZ0, and if a case occurs where the arc feature value ρ is less than the first arc determination threshold YZ0, determining that an arc fault has occurred, otherwise proceeding to a next step of determination;
2) comparing the arc feature value ρ with a second arc determination threshold YZ1, and if a case occurs where the arc feature value ρ is less than the second arc determination threshold YZ1, performing count accumulation to obtain an accumulated count value; wherein the first determination threshold YZ0 is less than the second determination threshold YZ1;
3) determining whether an arc fault has occurred according to the accumulated count value.

Further, determining whether an arc fault has occurred according to the accumulated count value is specifically:
when the accumulated count value is greater than 6 within 10 consecutive segments, determining that an arc fault has occurred; or when a case where the accumulated count value is greater than 1 and less than or equal to 6 within 10 consecutive segments occurs more than 4 times consecutively within a time window of 100 ms, determining that an arc fault has occurred.

The technical solution of the present invention uses the steady-state operating current in the circuit to perform normalization pre-processing on the arc current, reducing the influence of current amplitude on signal features, and solving the problem that arc identification parameters vary greatly under different rated operating currents. The mode function component IMF1 obtained via the complementary ensemble empirical mode decomposition algorithm in this solution has high anti-noise capability, which can effectively avoid interference of noise on algorithm identification during the arc identification process.

### DETAILED DESCRIPTION

To make the objectives, technical solutions, and advantages of the present invention clearer, the technical solutions of the present invention will be described clearly and completely below in junction with specific embodiments of the present invention. Apparently, the described embodiments are only a part of the embodiments of the present invention, and not all of them. All other embodiments conceived by a person skilled in the art without creative effort based on the embodiments of the present invention fall within the protection scope of the present invention.

The specific steps of the present invention are as follows:
Step 1: acquiring high-voltage DC arc fault data; and performing pre-processing on the arc current data.

A segment of high-voltage DC arc data is acquired via a current data acquisition device, wherein the arc data acquisition device satisfies the following conditions:
1) a sampling bandwidth is 200 kHz;
2) a sampling frequency is500 kHz;
3) a sampling duration is 10 s.

Normalization pre-processing is performed on the arc current data using a steady-state operating current. In the present embodiment, the steady-state operating current of the arc current is 3A. By sequentially dividing the arc current data by the steady-state current, normalized pre-processed arc current data Iarc are obtained.

Step 2: extracting, via a complementary ensemble empirical mode decomposition algorithm, an intrinsic mode function component IMF1. The specific implementation steps are as follows:
1) creating Gaussian white noise w0(t), and performing positive and negative modulation on the arc current signal to obtain a current signal mixed with positive white noise Iarc(0+) and a current signal mixed with negative white noise Iarc(0-), respectively: $Iarc \left(0+\right) = Iarc + w 0 \left(t\right) ;$ $Iarc \left(0-\right) = Iarc - w 0 \left(t\right) ;$
2) decomposing, via an empirical mode decomposition algorithm, the arc currents Iarc(0+) and Iarc(0-) with added white noises to obtain intrinsic mode function components C0+ and C0-, respectively;
3) repeating the above two steps by adding different noises Ci (i=1 ^{,} 2 ^{,} 3...) and performing empirical mode decomposition;
4) averaging all obtained intrinsic mode function components to obtain a final decomposition result: $S + = \frac{1}{N} {\sum }_{i}^{N} Ci +$ $S - = \frac{1}{N} {\sum }_{i}^{N} Ci - ;$
   finally obtaining the mode function component IMF1=(S+ + S-)/2.

Step 3: performing piecewise mean processing on the mode function component IMF1 to obtain an IMF1 mean;
1) dividing the mode function component IMF1 into n segments at a time interval of 100 µs, discarding a final data segment shorter than 100 µs;
2) finding, in each of the divided segments, extreme points and coordinates thereof respectively, and recording them as a maximum value Max(i) and maximum value coordinates Maxzb(i), and a minimum value Min(i) and minimum value coordinates Minzb(i), respectively, where i=1, 2, 3, ..., n;
3) reconstructing the mode function component IMF1 based on the coordinates of the extreme points and discarding the extreme points in the mode function component IMF1;
4) performing mean processing on the reconstructed mode function component IMF1, wherein if the calculated mode function component IMF1 is not an extreme point, three adjacent points are taken for mean processing; and if the calculated mode function component IMF1 is a point at an adjacent position of an extreme point, seven adjacent points are taken for mean processing.

Step 4: performing, via a Pearson correlation coefficient, feature extraction on the IMF1 mean;
1) dividing the mode function component IMF1 into m segments at a time interval of 100 µs to obtain a set of components imf1, imf2, ..., imfm, where m is an odd number greater than 5;
2) selecting two adjacent segments to calculate a Pearson correlation coefficient thereof to obtain an arc feature value ρ: $ρ \left(p\right) = \frac{E \left[\left(imf\left(p\right)-μimf\left(p\right)\right)\left(imf\left(p+1\right)-μimf\left(p+1\right)\right)\right]}{σimf \left(p\right) σimf \left(p+1\right)}$ where E represents expectation, µ represents standard deviation, σ represents variance, and p=1, ..., m-1.

Step 5: identifying, via a preset threshold determination strategy, an arc fault;
1) comparing each element in the arc feature value ρ with a first arc determination threshold YZ0, and if a case occurs where the arc feature value ρ is less than the determination threshold YZ0, determining that an arc fault has occurred, otherwise proceeding to a next step of determination;
2) comparing the arc feature value ρ with a second arc determination threshold YZ1, and if a case occurs where the arc feature value ρ is less than the determination threshold YZ1, performing count accumulation; wherein the first determination threshold YZ0 is less than the second determination threshold YZ1;
3) when the count is greater than 6 within 10 consecutive segments, determining that an arc fault has occurred; or when a case where the count is greater than 1 and less than or equal to 6 within 10 consecutive segments occurs more than 4 times consecutively within a time window of 100 ms, determining that an arc fault has occurred.

By adopting the above technical solution, the present invention has the following advantages:
This solution uses the steady-state operating current in the circuit to perform normalization pre-processing on the arc current, reducing the influence of current amplitude on signal features, and solving the problem that arc identification parameters vary greatly under different rated operating currents;
The mode function component IMF1 obtained via the complementary ensemble empirical mode decomposition algorithm in this solution has high anti-noise capability, which can effectively avoid interference of noise on algorithm identification during the arc identification process.

## Claims

1. An arc fault detection method based on complementary ensemble empirical mode decomposition, **characterized in that** the method comprises:
Step 1: acquiring high-voltage DC arc data and performing pre-processing to obtain data to be processed;
Step 2: extracting, via a complementary ensemble empirical mode decomposition algorithm, an intrinsic mode function component IMF1 of the data to be processed;
Step 3: performing piecewise mean processing on the mode function component IMF1 to obtain an IMF1 mean;
Step 4: performing, via a Pearson correlation coefficient, feature extraction on the IMF1 mean; and
Step 5: identifying, via a preset threshold determination strategy, an arc fault.

2. The arc fault detection method based on complementary ensemble empirical mode decomposition according to claim 1, **characterized in that** settings for acquiring high-voltage DC arc data in the Step 1 satisfy the following conditions:
1) a filter is disposed such that a sampling bandwidth of the high-voltage DC arc data is not higher than 200 kHz; and
2) a sampling frequency of the high-voltage DC arc data is not lower than 500 kHz, and a sampling duration of the high-voltage DC arc data is not lower than 10 s.

3. The arc fault detection method based on complementary ensemble empirical mode decomposition according to claim 1, **characterized in that** a specific method of the pre-processing in the Step 1 is as follows:
normalizing, via a steady-state operating current in a circuit, the high-voltage DC arc data to obtain data to be processed Iarc.

4. The arc fault detection method based on complementary ensemble empirical mode decomposition according to claim 1, **characterized in that** the Step 2 specifically comprises the following steps:
1) creating Gaussian white noise w0(t), and performing positive and negative modulation on the data to be processed Iarc to obtain a current signal mixed with positive white noise Iarc(0+) and a current signal mixed with negative white noise Iarc(0-), respectively: $Iarc \left(0+\right) = Iarc + w 0 \left(t\right) ;$ $Iarc \left(0-\right) = Iarc - w 0 \left(t\right) ;$
2) decomposing, via an empirical mode decomposition algorithm, the current signal mixed with positive white noise Iarc(0+) and the current signal mixed with negative white noise Iarc(0-) to obtain intrinsic mode function components C0+ and C0-, respectively;
3) repeating the above two steps by adding different noises and performing empirical mode decomposition to obtain corresponding intrinsic mode function components Ci+ and Ci-, where i=1, 2, 3, ..., N;
4) averaging all obtained intrinsic mode function components to obtain a final decomposition result: $S + = \frac{1}{N} {\sum }_{i}^{N} Ci +$ $S - = \frac{1}{N} {\sum }_{i}^{N} Ci - ;$ finally obtaining the intrinsic mode function component IMF1=(S+ + S-)/2, where N represents number of times white noises are added.

5. The arc fault detection method based on complementary ensemble empirical mode decomposition according to claim 1, **characterized in that** the Step 3 specifically comprises the following steps:
1) dividing the mode function component IMF1 into n segments at a time interval of 100 µs, discarding a final data segment shorter than 100 µs;
2) finding, in each of the divided segments, extreme points and coordinates thereof respectively, and recording them as a maximum value Max(k) and maximum value coordinates Maxzb(k), and a minimum value Min(k) and minimum value coordinates Minzb(k), respectively, where k=1, 2, 3, ..., n;
3) discarding the extreme points in the mode function component IMF1 to obtain a reconstructed mode function component IMF2;
4) performing mean processing on the reconstructed mode function component IMF2, wherein for points at adjacent positions of the extreme points in the reconstructed mode function component IMF2, j adjacent points of the points at the adjacent positions are taken for mean processing; and for other non-extreme points in the reconstructed mode function component IMF2, three adjacent points of the non-extreme points are taken for mean processing, where j is a set value.

6. The arc fault detection method based on complementary ensemble empirical mode decomposition according to claim 5, **characterized in that** the Step 4 specifically comprises the following steps:
1) dividing the mode function component IMF1 mean into m segments at a time interval of 100 µs to obtain a set of components imf1, imf2, ..., imfm, where m is an odd number greater than 5;
2) selecting two adjacent segments to calculate a Pearson correlation coefficient thereof to obtain an arc feature value ρ based on the following calculation formula: $ρ \left(p\right) = \frac{E \left[\left(imf\left(p\right)-μimf\left(p\right)\right)\left(imf\left(p+1\right)-μimf\left(p+1\right)\right)\right]}{σimf \left(p\right) σimf \left(p+1\right)}$ where E represents expectation, µ represents standard deviation, σ represents variance, and p=1, ..., m-1.

7. The arc fault detection method based on complementary ensemble empirical mode decomposition according to claim 1, **characterized in that** the Step 5 specifically comprises the following steps:
1) comparing each element in the arc feature value ρ with a first arc determination threshold YZ0, and if a case occurs where the arc feature value ρ is less than the first arc determination threshold YZ0, determining that an arc fault has occurred, otherwise proceeding to a next step of determination;
2) comparing the arc feature value ρ with a second arc determination threshold YZ1, and if a case occurs where the arc feature value ρ is less than the second arc determination threshold YZ1, performing count accumulation to obtain an accumulated count value; wherein the first determination threshold YZ0 is less than the second determination threshold YZ1;
3) determining whether an arc fault has occurred according to the accumulated count value.

8. The arc fault detection method based on complementary ensemble empirical mode decomposition according to claim 7, **characterized in that** determining whether an arc fault has occurred according to the accumulated count value comprises:
when the accumulated count value is greater than 6 within 10 consecutive segments, determining that an arc fault has occurred; or when a case where the accumulated count value is greater than 1 and less than or equal to 6 within 10 consecutive segments occurs more than 4 times consecutively within a time window of 100 ms, determining that an arc fault has occurred.
